(19) Europäisches Patentamt
European Patent Office
Office européen des brevets

(11) EP 0 160 456 B1

(12) **EUROPEAN PATENT SPECIFICATION**

(45) Date of publication and mention
of the grant of the patent:
**17.07.1996  Bulletin 1996/29**

(51) Int Cl.$^6$: **H01L 39/22**

(21) Application number: **85302732.4**

(22) Date of filing: **18.04.1985**

(54) **Superconducting device**

Supraleitende Anordnung

Dispositif supraconducteur

(84) Designated Contracting States:
**DE GB**

(30) Priority: **19.04.1984  JP  77563/84**
**21.09.1984  JP  196830/84**

(43) Date of publication of application:
**06.11.1985  Bulletin 1985/45**

(73) Proprietor: **HITACHI, LTD.**
**Chiyoda-ku, Tokyo 100 (JP)**

(72) Inventors:
• **Harada, Yutaka**
  **Kodaira-shi Tokyo (JP)**
• **Shinichiro, Yano**
  **Hachioji-shi Tokyo (JP)**
• **Miyake, Mutsuko**
  **Urawa-shi Saitama-ken (JP)**
• **Kawabe, Ushio**
  **Nishitama-gun Tokyo (JP)**
• **Nishino, Toshikazu**
  **Kawasaki-shi Kanagawa-ken (JP)**

(74) Representative: **Calderbank, Thomas Roger et al**
**MEWBURN ELLIS**
**York House**
**23 Kingsway**
**London WC2B 6HP (GB)**

(56) References cited:
**EP-A- 0 147 482**

• **RADIO ENGINEERING AND ELECTRONIC PHYSICS, vol. 22, no. 11, November 1977, pages 107-113, Scripta Publishing Co., Washington, US; V.N. ALFEYEV: "Amplification properties of superconductor-semiconductor contacts"**

## Description

The present invention relates to a superconducting device which operates at a cryogenic temperature.

It is known to combine in one superconducting device both a semiconductor and a superconductor. An example of such a device is the hybrid Josephson field effect transistor (hereinafter abbreviated to JOFET) proposed by T.D. Clark et al (J. Appl. Phys. 51(5) 2736 - 2743 (1980)). This JOFET has a structure in which the semiconductor (normal conductor) and the superconductor are joined. Electron pairs or Cooper pairs in the superconductor percolate into the semi-conductor to a depth corresponding to a coherent length. It is the principle of the JOFET that the Cooper pairs which have percolated into the semiconductor move within the plane of the semiconductor. In such a JOFET, the Cooper pairs are supplied from a gate electrode and so the current gain cannot exceed 1 (one). Therefore, the circuit gain is disadvantageously small.

Other superconducting devices in which a semiconductor and a superconductor are combined are disclosed in e.g. JP-A-57-176781 and JP-A-57-106108. The device of JP-A-57-176781 uses a semiconductor material which falls into a superconducting state at a temperature 5 below a superconducting transition temperature $T_c$. The transition temperature $T_c$ in this case is, in general, approximately equal to or lower than the temperature of liquid Helium (He) (4.2 K). Therefore if the operation of a circuit containing such a device is to be stable, the device needs to be cooled to a temperature below 4.2 K. The device of JP-A-57-106186 has a structure in which a control electrode is disposed in the narrow space between superconducting electrodes, so that the fabrication of the control electrode is difficult.

An article by V.N. Alfeyev entitled "Amplification properties of superconductor semi-conductor contacts" in "Radio Engineering and Electronic physics" Vol 22, No 11, of November 1977 pages 107-113, by Scripta Publishing Co. Washington, US, also discloses a superconducting device with superconducting electrodes on one side of a semiconductor. There is also an electrode between the superconducting electrodes for controlling the superconducting current flowing between the superconducting electrodes. Thus, this document corresponds to the pre-characterising part of claim 1.

The present invention seeks to solve or at least ameliorate the problems of the prior art.

In a first aspect, the present invention provides a superconducting device comprising:

a semiconductor layer having an upper side and a lower side, a first and a second superconducting electrodes located at the upper side of the semiconductor layer having a spacing therebetween, and a controlling electrode for controlling superconducting current flowing between said superconducting electrodes through the semiconductor layer.;

wherein the controlling electrode is located at the lower side of the semiconductor layer and aligned with the spacing.

An example of this construction has two superconducting electrodes on the upper side of a semiconductor, and there is an electrode for controlling the superconducting current flowing across the superconducting current flowing across the superconducting electrodes on the lower side of the semiconductor. In order to prevent the current through the semiconductor from flowing into the control electrode, there is an insulator film between the control electrode and the semiconductor, or the control electrode and the semiconductor are joined into a p-n junction.

Another example of the present invention has at least one superconducting electrode between a source electrode and a drain electrode, and the number of Cooper pairs having percolated from the superconducting electrode into a semiconductor is controlled by a control electrode disposed on the lower side of the semiconductor, so that the superconducting current flowing across the source electrode and the drain electrode is controlled.

If two superconducting electrodes are formed on the upper side of the semiconductor, the operation of the device is satisfactory if the two superconducting electrodes are disposed at a distance at which they form a superconducting weak link. It has been found that, if the semiconductor is silicon, the spacing between the superconducting electrodes must be not more than 300 nm. This is the second aspect of the present invention.

Embodiments of the invention will now be described, by way of example, with reference to the accompanying drawings, in which:

Figs. 1, 3 and 4 are sectional views showing parts of superconducting devices being a first, second, and third embodiment of the present invention respectively;

Fig. 2 is a diagram illustrating the characteristics of the superconducting device of the first embodiment of the present invention shown in Fig. 1;

Figs. 5 - 8 are diagrams each showing the band state of the superconducting device of the first embodiment of the present invention;

Fig. 9 is a view showing a fourth embodiment the present invention;

Fig. 10 is a diagram illustrating the operation of the fourth embodiment;

Fig. 11 is a view showing a fifth embodiment of the present invention;

Fig. 12 is a diagram illustrating the operation of the fifth embodiment;

Figs. 13 and 14 are energy band structure diagrams of the device of the fifth embodiment; and

Fig. 15 is a diagram showing a circuit in which a superconducting switching device according to the present invention and a Josephson junction device are used together.

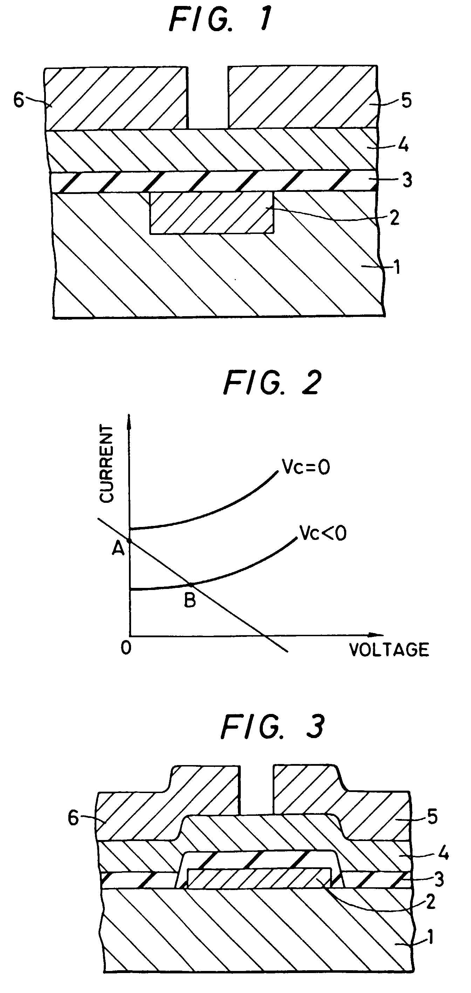

Fig. 1 shows a first embodiment of the present invention. An impurity B was introduced to a concentration of $10^{18}$ to $10^{20}$ cm$^{-3}$ into a substrate 1 made of n-type Si and having an impurity concentration of not more than $10^{15}$ cm$^{-3}$, to form a p-type control electrode 2 having a depth of 1 to 2 μm. The substrate 1 was preferably formed from a material which becomes semi-insulating at a cryogenic temperature. Next, the front surface of the substrate 1 was oxidized to form an insulator film 3 made of SiO$_2$ approximately 30 nm thick. Subsequently, a semiconductor layer 4 made of Si approximately 100 nm thick was formed by vapour deposition or molecular beam epitaxy. The advantages of the present invention could be achieved in both when the semiconductor layer 4 was in an amorphous state and when in a polycrystalline state. An n-type impurity (As or p) was introduced into the semiconductor layer 4 to a concentration of 5 x $10^{19}$ to $10^{20}$ cm$^{-3}$, Subsequently, first and second superconducting electrodes 5 and 6 in the shape of belts each having a width of approximately 5 μm were formed on the same side of the substrate 1. The material forming the superconducting electrodes should desirably be Pb, alloys containing Pb as their principal ingredients, Nb, or Nb compounds. The use of such materials permits the device to operate in liquid He. However, the present invention is not limited to the use of those materials. In the way described above, the superconducting device of the present invention was fabricated.

In this device, the superconducting electrodes 5 and 6 are coupled by a superconducting weak link when the device is cooled to or below the transition temperature of the material of the superconducting electrode, so that the maximum Josephson current I$_m$ flowing across the two superconducting electrodes is given by the following equation:

$$I_m = 4 \pi \Delta/2 \, e \, R_N \qquad (1)$$

Where:

Δ denotes the gap energy of the superconducting electrodes 5 and 6,
e the elementary charge, and
R$_N$ the normal tunnelling resistance of the superconducting weak link.

The spacing between the two superconducting electrodes 5 and 6 is desirably 300 nm or less in order to form the superconducting weak link, and both the electrodes 5 and 6 should desirably be spatially separated.

Where a negative voltage relative to the superconducting electrode 5 or 6 is applied to the control electrode 2, positive charges are induced on the side of the semiconductor layer 4 at the interface between this semiconductor layer 4 and the insulator film 3. These charges change the state of the tunnel barrier and the tunnelling resistance R$_N$ changes to a larger value, so that there is a decrease in the maximum Josephson current I$_m$ which flows without generating any voltage across the electrodes 5 and 6. Thus the semiconductor is used as a tunnelling barrier layer to superconducting tunnelling and the voltage applied to the control electrode on the semiconductor, through an insulator film approximately 10 to 30 nm thick, is used for changing the quantity of space charges within the semiconductor. This changes the width and heighth of the tunnel barrier (a barrier to the tunnelling of Cooper pairs through the semiconductor portion), thereby causing the device to operate. Therefore, the semi-conductor need not be used at a temperature below the superconducting transition temperature thereof. In addition, since the control electrode is not used for the supply of Cooper pairs, the gain of the device may be high.

Fig. 2 shows the characteristics of the superconducting device according to the first embodiment. With a load line as shown in this figure, the operating point is at a point A when the voltage V$_c$ of the control electrode 2 is zero, but is switched to a point B by the application of a signal of a gate voltage V$_G$ < 0, Since, on this occasion, the control electrode 2 is separated from the semiconductor layer 4 by the insulator film 3, this device has voltage-controlled operation.

The embodiment shown in Fig. 1 uses a control electrode 2 of p-type semiconductor and a semiconductor layer 4 of n-type, but it is also possible to use a control electrode 2 of n-type semiconductor and a semiconductor layer 4 of p-type. In addition, material of the semiconductor layer 4 may be e.g. Ge, GaAs, InAs, InP, or InSb, rather than Si. When a thin film of SiO or Si$_3$N$_4$ was used as the material of the insulator film 3, the operation was similar to that described above. In this case, a carrier concentration of at least 6 x $10^{18}$ cm$^{-3}$ for Ge, a carrier concentration of at least 1 x $10^{17}$ cm$^{-3}$ for GaAs or InP, and a carrier concentration of at least 1 x $10^{16}$ cm$^{-3}$ for InAs or InSb are desirable for the device to operate at a cryogenic temperature. However, even when the carrier concentrations were below the numerical value mentioned here, the advantages of the present invention could be achieved by enlarging the voltage to be applied to the control electrode.

As described above, n-type semiconductor was employed for the susbtrate 1 and p-type semiconductor material for the semiconductor layer 4. However, similar effects could be attained even when p-type semiconductor was employed for the substrate 1 and n-type semiconductor for the semiconductor layer 4 and where a positive voltage was applied to the control electrode 2.

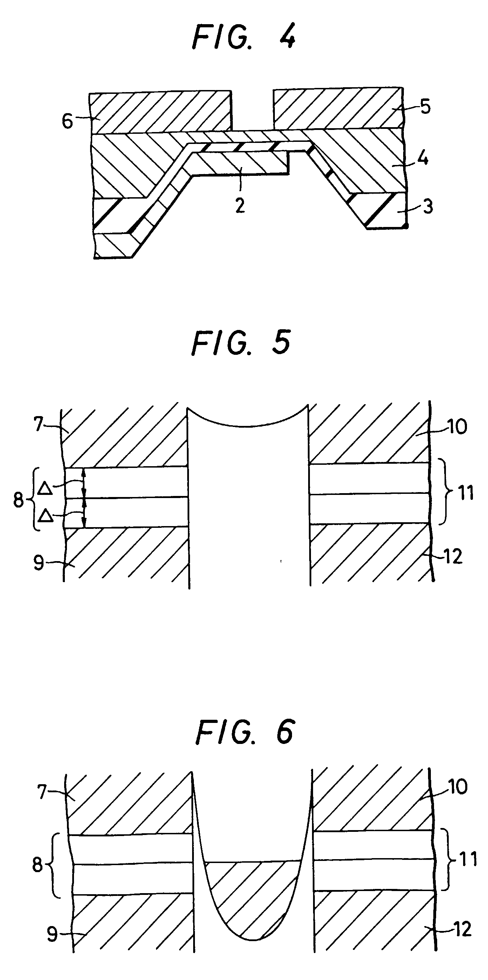

Band diagrams of the interspace between the first and second superconducting electrodes of the superconducting device shown in Fig. 1 are shown in Figs. 5, 6, 7, and 8.

Each of these figures show the conduction band 7 of the first superconducting electrode, the forbidden band 8 of the first superconducting electrode, the valence band of the first superconducting electrode 9, the conduction band 10 of the second superconducting electrode, the forbidden band 11 of the second superconducting electrode and the valence band 12 of the second superconducting electrode.

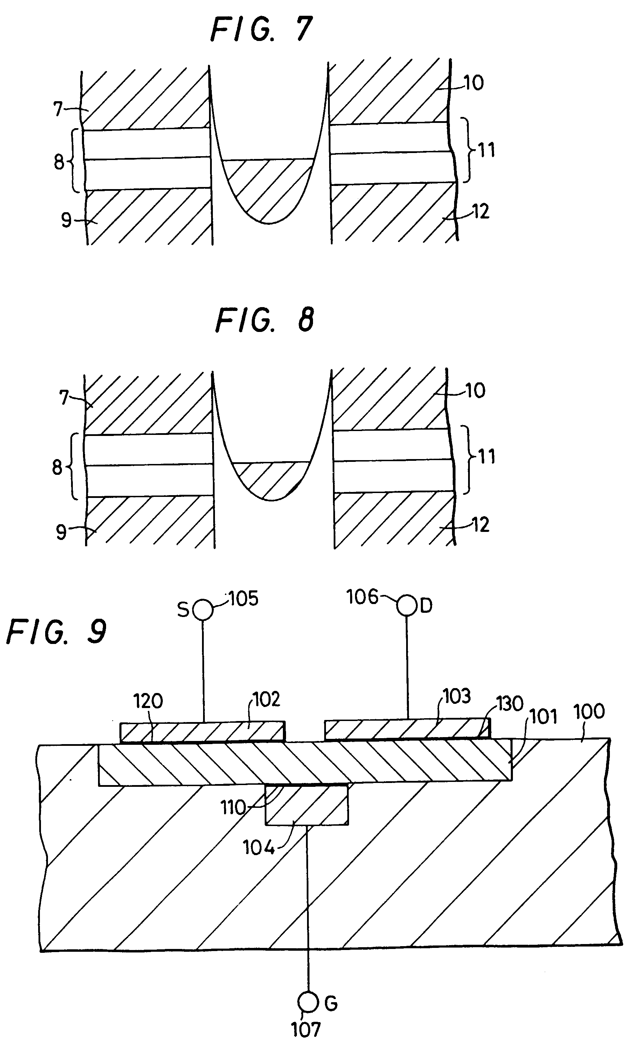

Fig. 5 corresponds to the use of a nondegenerate semiconductor material, and Fig. 6 corresponds to the use of a degenerate semiconductor material, when no voltage is applied to the control electrode. When a voltage is applied to the control electrode, the band diagram becomes as shown in Fig. 7 for a nondegenerate semiconductor, and as shown in Fig. 8 for a degenerate semiconductor. In the former, the superconducting critical current increases to perform switching, whereas in the latter, it decreases to perform the same.

Fig. 3 shows a second embodiment of the present invention. A control electrode 2 was formed by fabricating Nb, being a superconducting metal, into a film approximately 200 nm thick by a sputtering technique employing Ar gas. The film was then processed by a reactive ion etching technique employing $CF_4$ gas. Subsequently, an amorphous $SiO_2$ film approximately 50 nm thick was deposited by CVD on the surface of the resultant structure, to form an insulator film 3. Next, using the RF discharge of silane gas, an amorphous silicon film which contained P to a high concentration of at least $10^{19}$ $cm^{-3}$ and which was approximately 200 nm thick was formed into a semiconductor layer 4. Lastly, superconducting electrodes 5 and 6 made of Nb and approximately 300 nm thick were formed by sputtering and processed by reactive ion etching. In this embodiment, the structure of the superconducting device is the same as in the first embodiment, but a superconducting metal is used for the control electrode 2. Although the insulator film 3 should desirably be the native oxide film of this superconducting metal, a thin film of e.g. $SiO_2$, SiO, or $Si_3N_4$ may well be deposited and used. The superconducting metal should desirably be Nb, compounds of Nb, or Ta so as to increase the relative dielectric constant of the insulator film 3, but the invention is not limited to the use of these materials. Thus, the operating voltage of the device may be rendered low, and the power consumption may be reduced.

Fig. 4 shows a third embodiment of the present invention. In this embodiment, an Si single crystal forms a semiconductor layer 4. The Si single crystal may be of p-type or n-type, and should desirably have an impurity concentration of not more than $1 \times 10^{19}$ $cm^{-3}$.

An Si single crystal of (100) orientation was processed as shown in Fig. 4 by anisotropic etching with KOH and using e.g. $SiO_2$ as a mask, to form a very thin semiconductor layer 4 which was approximately 100 to 200 nm thick. The surface of the semiconductor layer 4 was oxidized to form an insulator film 3. Pb was used as a control electrode 2, being a superconducting metal which was deposited to approximately 500 nm by vapour deposition and thereafter processed. Subsequently, the upper surface of the semiconductor layer 4 was cleaned, and superconducting electrodes 5 and 6 made of Nb or Pb and approximately 300 nm thick were formed by preparing a film and processing it by reactive ion etching. Such a structure permitted effects similar to those of the first embodiment to be attained.

In the above embodiments, the semiconductor layer 4 (which may well be a semiconductor body) between the first and second superconducting electrodes 5 and 6 is underlain by the control electrode 2 through the insulator film 3.

A superconducting device fabricated in the above way has a small static capacitance in parallel with the superconducting weak link, so that the hystereses characteristics are small, and a D.C. power system can be used instead of an A.C. power system. An A.C. power system hampers the enhancement of the speed of a conventional Josephson circuit and the simplification of the circuit. Moreover, even if the device is of the voltage-controlled type and uses a semiconductor, the high frequency response is not limited by the mobility of semiconductor carriers because the tunnel effect is utilized, and a high switching speed can be obtained.

Fig. 9 shows a fourth embodiment of the present invention. A silicon substrate 100 having an impurity concentration of $10^{15}$ $cm^{-3}$ is formed with a p-type buried electrode 104, and is also formed with an n-type channel layer 101 having a depth of 0.1 to 0.15 $\mu$m by introducing an impurity (As or P) to a concentration of $10^{18}$ to $10^{20}$ $cm^{-3}$. The p-type buried electrode 104 and the n-type channel layer 101 lie in contact through a p-n junction 110. First and second superconducting electrodes 102 and 103 formed by vapour deposition are disposed at end parts of the n-type channel layer 101, and first and second junctions 120 and 130 are interposed between these electrodes and the n-type channel layer 101. The spacing between the two superconducting electrodes 102 and 103 is small (300 nm), as in the first embodiment, and the two electrodes form superconducting weak link. The first and second junctions 120 and 130 form Schottky barriers, which are very thin, so that electrons can pass therethrough by tunnelling. The p-type buried electrode 104 is connected to a gate terminal 107, and the first and second superconducting electrodes 102 and 103 are respectively connected to a source terminal 105 and a drain terminal 106.

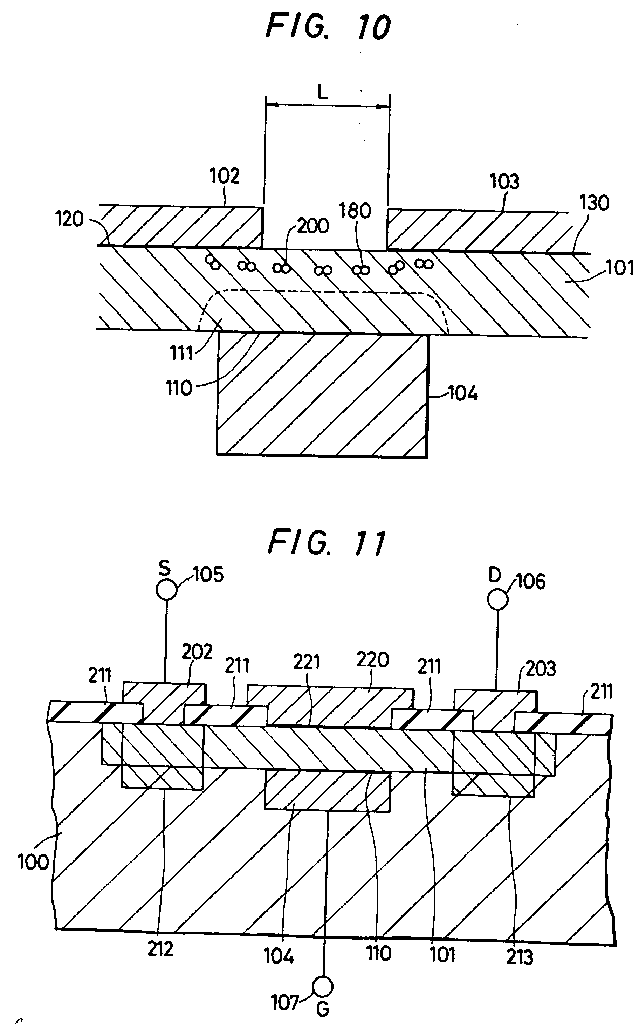

The operation of the switching device shown in Fig. 9 will now be described with reference to Fig. 10. The n-type channel layer 101 is supplied with Cooper pairs 200 through the first Schottky junction 120 from the first superconducting electrode 102. Likewise, the n-type channel layer 101 is supplied with Cooper pairs 180 through the second Schottky junction 130 from the 5 second superconducting electrode 103. As stated before, the spacing L between the two superconducting electrodes is very small, e.g. 300 nm, and the two superconducting electrodes are weakly linked, so that a superconducting current flows across them. The maximum superconducting current $I_m$ which can flow across the two electrodes is expressed by Equation (1) mentioned before. The normal tunnelling resistance $R_N$ is controlled by a voltage which is applied to the p-type buried electrode 104.

As described above, the p-type buried electrode 104 and the n-type channel layer 101 lie in contact through the p-n junction 110. A depletion layer 111 spreads into the n-type channel layer 101 from the p-n junction 110, and the thickness of this depletion layer 111 changes depending upon the voltage applied to the p-type buried electrode 104. For example, when the reverse bias voltage applied to the p-n junction 110 is increased, the thickness of the depletion layer 111 increases. In consequence, the effective thickness of the n-type channel layer 101 decreases, and the normal tunnelling resistance $R_N$ of the n-type channel layer 101 increases. As is evident from Equation (1), therefore, there is a decrease in the maximum superconducting current flowing across the two superconducting electrodes 102 and 103. It is obvious from this that the maximum superconducting current flowing across the two superconducting electrodes 102 and 103 can be controlled by the voltage applied to the p-type buried electrode 104.

According to this fourth embodiment, the p-type buried electrode 104, acting as a gate, is isolated from the n-type channel layer 101 by the p-n junction 110. Therefore, no signal current flows to the p-type buried electrode 104 and the device shown in Fig. 9 is a device which is driven by a voltage input signal. While the embodiment shown in Fig. 9 uses a combination between a p-type buried electrode and an n-type channel layer, the present invention may also be performed with a combination between an n-type buried electrode and a p-type channel layer.

Fig. 11 shows a fifth embodiment of the present invention. As in the fourth embodiment, a silicon substrate 100 has a p-type buried electrode 104 and an n-type channel layer 101. The p-type buried electrode 104 and the n-type channel layer 101 lie in contact through a p-n junction 110. A superconducting electrode 220, which is formed by vapour deposition and which is 0.2 to 1 $\mu$m thick, lies in contact with the front surface of the n-type channel layer 101 through a Schottky barrier 221. Both the end parts of the n-type channel layer 101 lie in ohmic contact with first and second electrodes 202 and 203 through n-type contact layers 212 and 213 having an impurity concentration of $10^{20}$ to $10^{21}$ cm$^{-3}$. The respective electrodes are isolated by insulator layers 211 (for example, SiO layers or SiO$_2$ layers) so as not to lie in contact with the Si substrate 100 or the channel layer 101. The p-type buried electrode 104 is connected to a gate terminal 107, and the first and second electrodes 202 and 203 are respectively connected to a source terminal 105 and a drain terminal 106.

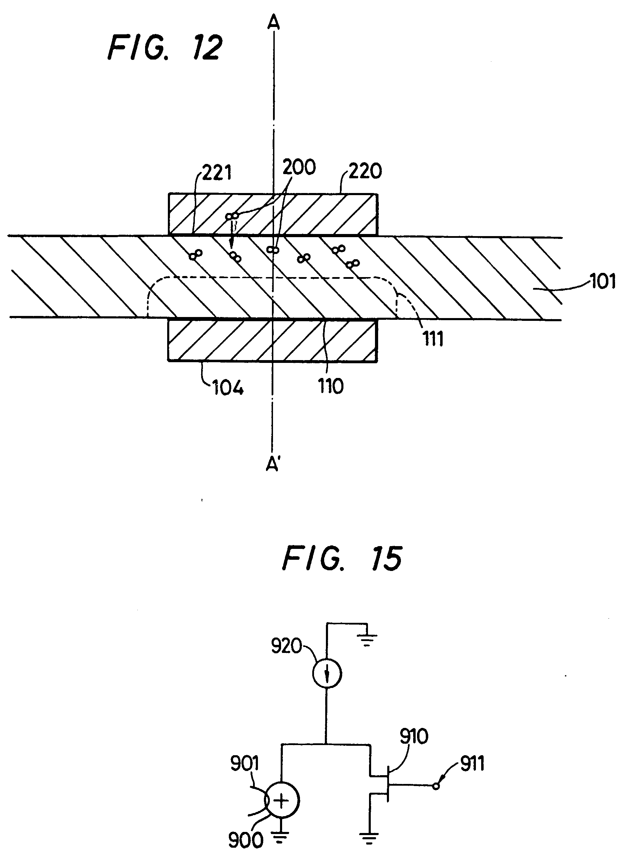

The operation of the switching device shown in Fig. 11 will be described with reference to Fig. 12. Cooper pairs 200 percolate from the superconducting electrode 220 into the n-type channel layer 101 through the Schottky barrier 221. The Cooper pairs 200 spread within the semiconductor to a depth corresponding to a coherent length (1 to 0.1 $\mu$m), and they move laterally in the semiconductor, so that a superconducting current flows across the two electrodes 202 and 203. The maximum superconducting current which flows through the n-type channel layer 101 is expressed by Equation (1). The normal tunnelling resistance $R_N$ of the n-type channel layer 101 can be controlled by a voltage which is applied to the p-type buried layer 104. The principle of operation is similar to that of the fourth embodiment.

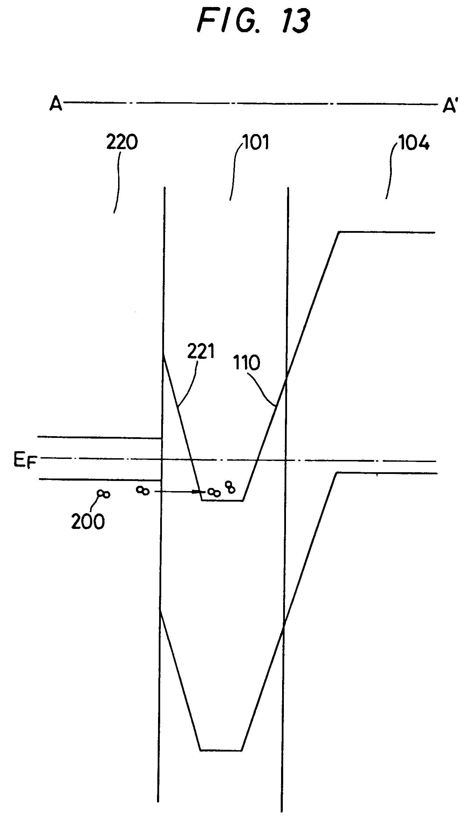

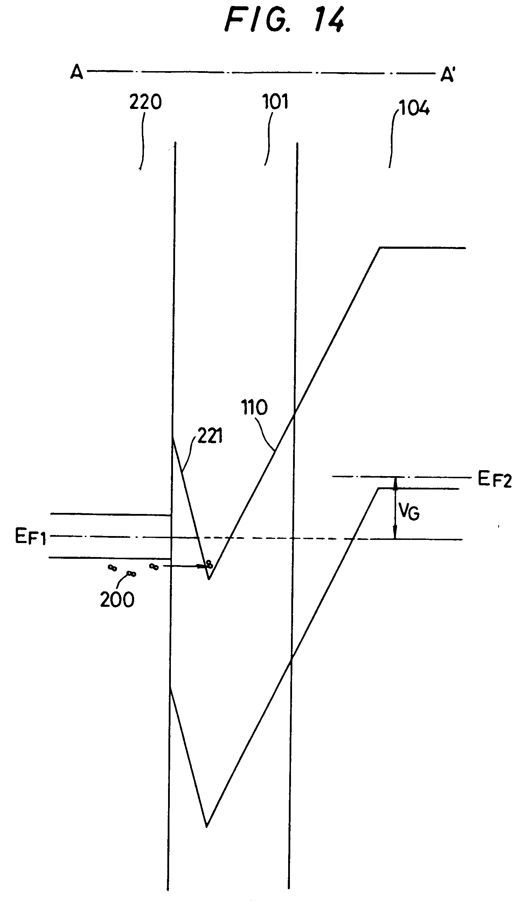

The operation of the embodiment shown in Fig. 11 will be described with reference to the energy band structures shown in Figs. 13 and 14. Figs. 13 and 14 are diagrams showing the energy band structures at a position A - A' in Fig. 12, and Fig. 13 corresponds to the structure when no voltage is applied to the p-type buried electrode 104, while Fig. 14 to the structure in which a voltage is applied to the p-type buried electrode 104 so that the p-n junction 110 is reverse-biased. When no voltage is applied, the Fermi levels $E_F$ of the superconducting electrode 220, n-type channel layer 101 and p-type buried electrode 104 are in agreement. Since the n-type channel layer 101 is doped with an impurity to a high concentration of the order of $10^{19}$ cm$^{-3}$, the Fermi level of the n-type channel layer 101 is 100 to 200 mV above the lower end of the conduction band. The Schottky barrier 221 is as thin as 1 to 2 nm (10 to 20 Å), and electrons can pass freely therethrough. Therefore, the Cooper pairs 200 of the superconducting electrode 220 pass through the Schottky barrier 221 to percolate into the n-type channel layer 101. In the n-type channel layer 101, the valley of energy is formed by the Schottky barrier 221 and the p-n junction 110. The Cooper pairs 200 percolated into the n-type channel layer 101 are stored in this valley of energy. The stored Cooper pairs move laterally in the semiconductor, and form the superconducting current.

On the other hand, when a reverse bias voltage is applied to the p-type buried electrode 104 as illustrated in Fig. 14, the thickness of the depletion layer of the p-n junction 110 increases, and the valley of energy storing the Cooper pairs becomes small. Consequently, the number of stored Cooper pairs decreases, and the maximum superconducting current decreases. Thus the maximum superconducting current which flows across the two electrodes 202 and 203 can be controlled by the voltage which is applied to the p-type buried electrode 104.

According to the fifth embodiment, the p-type buried electrode 104, acting as a gate, is isolated from the n-type channel layer 101 by the p-n junction 110. Therefore, no input current flows to the p-type buried electrode 104 and the device shown in Fig. 11 is a device which is driven by a voltage input signal.

While the embodiment shown in Fig. 11 uses a combination between a p-type buried electrode and an n-type channel layer, the present invention may also be performed with a combination between an n-type buried electrode and a p-type channel layer.

Further, in the fifth embodiment, the number of the Cooper pairs percolating into the n-type channel layer 101 is changed by changing the potential of the superconducting electrode 220. Therefore, the superconducting electrode 220 can also be used as the offset electrode of the switching device.

The above embodiments use Si for the substrate, but Ge, GaAs, InSb, or InAs may also be employed. The element or compounds of Pb, Nb or In can be used as the material of the superconducting electrode.

The voltage to be applied to the gate or the source or drain is, for example, 0 to 10 mV, and the current to flow is, for example, 100 μA for a gate width of 10 μm.

The reason why the voltage gain is enhanced by the present invention will now be explained. In the prior-art device proposed by Clark referred to above, Cooper pairs are supplied from a gate electrode to a channel, and the Cooper pairs move within the channel. When an input signal voltage changes, an input signal current corresponding to the change flows into the channel, and it flows into a drain electrode. That is, the same quantity of current as the input signal is obtained as an output current. This means that the input impedance of the circuit is small. With this circuit, the gain, especially the current gain, cannot be high. On the other hand, in the device according to the present invention, Cooper pairs are supplied from an electrode which is not the gate electrode. The gate electrode and the channel are insulated by, for example, the p-n junction. Therefore, even when the input signal voltage changes, no current flows into the gate electrode. Thus a device according to the present invention is a device of high input impedance wherein the gate electrode is insulated and wherein no input current flows even when the input voltage changes. Accordingly, a circuit employing the device of the present invention, the current gain can be enlarged, and in turn, the voltage gain can be enlarged.

The superconducting switching device according to the present invention may be used in coexistance with other superconducting switching devices, for example, Quiteron and Josephson junction devices and with superconducting strip lines (including superconducting transmission lines). The superconducting strip line is indispensable to a high speed circuit of small signal voltage amplitude because there is no voltage drop attributed to current flowing through the strip line. This is not available with conventional semiconductor technologies represented by a silicon semiconductor. The Josephson junction device is a switching device of the highest speed. The superconducting switching device according to the present invention can be operated in coexistance with a Josephson junction device, and may improve the performance of the Josephson junction device. Fig. 15 shows an example in which the superconducting switching device according to the present invention and a Josephson junction device are used together. The Josephson junction device is described in detail in "Josephson Computer Technology" IBM R & D, vol. 124, No. 2 (1980) by Anacker et al. The example of Fig. 15 has a low current source 920 connected to a circuit in which a Josephson junction device 900 and a superconducting switching device 910 according to the present invention are connected in parallel. Under a voltage state, the Josephson junction device operates in the so-called latching mode in which it does not shift into a superconducting state unless the current flowing therethrough is below a fixed magnitude. There has been proposed a circuit of the so-called A.C. power system, in which a supply voltage is reduced in order to shift the Josephson junction device under the voltage state into the superconducting state. In the circuit of this sytem, the frequency of an A.C. power supply serves as a clock frequency. With the A.C. power supply of high frequency, high speed operation is limited because of large quanitites of crosstalk noise between circuits. The circuit shown in Fig. 15 is a switching circuit adapted to be driven by a D.C. power supply, which is based on the principle that in order to shift the Josephson junction device 900 from the voltage state into the superconducting state, the superconducting switching circuit according to the present invention connected in parallel therewith is switched.

Now, the operation of the circuit shown in Fig. 15 will be described. When the Josephson junction device 900 is in the superconducting state, all the current of the low current source 920 flows into the Josephson junction device 900. Under this condition, current flows through the input line 901 of the Josephson junction device 900 so as to shift this Josephson junction device into the voltage state. When the voltage of the input terminal 911 of the superconducting switching device 910 according to the present invention is raised under the voltage state of the Josephson junction device, current flows into the superconducting switching device 910, and the current flowing through the Josephson junction device 900 decreases, so that the Josephson junction device 900 shifts into the superconducting state. Since the circuit of Fig. 15 is driven by a D.C. power source and does not use an A.C. power source, it is capable of operating at high speed. It is obvious from the example of Fig. 15 that the superconducting device according to the present invention and the Josephson junction device can coexist in a circuit and that the performance of the Josephson junction device may be satisfactory.

**Claims**

1. A superconducting device comprising:

a semiconductor layer (4,100,101) having an upper side and a lower side, a first and a second superconducting electrode (5,6, 102, 103, 202, 203) located on the upper side of the semiconductor layer (4, 100, 101) having a spacing therebetween, and a controlling electrode (2, 104) for controlling superconducting current flowing between said superconducting electrodes (5,6, 102, 103, 202, 203) through the semiconductor layer (4,100,101);
characterised in that:
the controlling electrode (2,104) is located on the lower side of the semiconductor layer (4,100,101) and opposite the spacing.

2. A superconducting device according to claim 1, wherein the width of the controlling electrode (2) is larger than the spacing between the superconducting electrodes (5,6).

3. A superconducting device according to claim 1 or claim 2, wherein the first and the second superconducting electrodes (5,6, 102, 103, 202, 203) are coupled by a superconducting weak link through the semiconductor layer (4,100,101).

4. A superconducting device according to any one of the preceding claims wherein the semiconductor layer (4) is used as a tunnelling barrier to the superconducting current.

5. A superconducting device according to any one of claims 1 to 4 wherein the controlling electrode (2) is located so as to be buried in a semiconductor substrate (1).

6. A superconducting device according to any one of the preceding claims wherein the semiconductor layer (4,100,101) is comprised of a semiconductor material having a first conductivity type, and the controlling electrode (2,104) is comprised of a semiconductor material having a second conductivity type.

7. A superconducting device according to any one of the preceding claims wherein the controlling electrode (2) is insulated from the semiconductor layer (4).

8. A superconducting device according to any one of claims 1 to 6 wherein the semiconductor layer (100, 101) is comprised of an n-type semiconductor material, whereby the semiconductor layer (100, 101) and the controlling electrode (104) form a p-n junction therebetween.

9. A semiconductor device according to any one of the preceding claims, wherein the semiconductor layer (4) has a region which corresponds to the spacing and is thinner than other regions thereof.

10. A superconducting device according to claim 9, wherein the superconducting current flows through the thinner region.

11. A superconducting device according to claim 9 or claim 10, wherein the thinner region is a recessed thinner region of a semiconductor substrate.

12. A superconducting device according to any one of the preceding claims wherein the semiconductor layer (4) is a semiconductor layer located on a semiconductor substrate.

13. A superconducting device according to any one of claims 1 to 11 wherein the semiconductor layer (4) is is a region formed in a semiconductor substrate (1).

14. A superconducting device according to any one of the preceding claims wherein a controlling voltage is applied to the controlling electrode (2) so as to control the superconducting current.

15. A superconducting device according to any one of the preceding claims, wherein the semiconductor layer (4,101) is a silicon semiconductor; the spacing between the two superconducting electrodes (5,6,102,103) is not more than 300nm and the controlling electrode (2,104) controls a normal tunnelling resistance of the superconducting weak link between said superconducting electrodes (5,6,102,103).

**Patentansprüche**

1. Supraleitungs-Bauelement mit:

- einer Halbleiterschicht (4, 100, 101) mit einer Oberseite und einer Unterseite, einer ersten und einer zweiten supraleitenden Elektrode (5, 6, 102, 103, 202, 203), die auf der Oberseite der Halbleiterschicht (4, 100, 101) angeordnet sind und die einen Abstand einhalten, und einer Steuerelektrode (2, 104) zum Steuern des Supraleitungsstroms, der zwischen den supraleitenden Elektroden (5, 6, 102, 103, 202, 203) durch die Halbleiterschicht (4, 100, 101) fließt;

**dadurch gekennzeichnet, daß**

- die Steuerelektrode (2, 104) an der Unterseite der Halbleiterschicht (4, 100, 101), dem Abstand gegenüberliegend angeordnet ist.

2. Supraleitungs-Bauelement nach Anspruch 1, bei dem die Breite der Steuerelektrode (2) größer als der Abstand zwischen den supraleitenden Elektroden (5, 6) ist.

3. Supraleitungs-Bauelement nach Anspruch 1 oder Anspruch 2, bei dem die erste und die zweite supraleitende Elektrode (5, 6, 102, 103, 202, 203) mittels einer supraleitenden, schwachen Verbindung durch die Halbleiterschicht (4, 100, 101) gekoppelt sind.

4. Supraleitungs-Bauelement nach einem der vorstehenden Ansprüche, bei dem die Halbleiterschicht (4) als Tunnelbarriere gegen den Supraleitungsstrom verwendet ist.

5. Supraleitungs-Bauelement nach einem der Ansprüche 1 bis 4, bei dem die Steuerelektrode (2) so angeordnet ist, daß sie in einem Halbleitersubstrat (1) vergraben ist.

6. Supraleitungs-Bauelement nach einem der vorstehenden Ansprüche, bei dem die Halbleiterschicht (4, 100, 101) aus einem halbleitenden Material von erstem Leitungstyp besteht und die Steuerelektrode (2, 104) aus einem Halbleitermaterial von zweitem Leitungstyp besteht.

7. Supraleitungs-Bauelement nach einem der vorstehenden Ansprüche, bei dem die Steuerelektrode (2) gegen die Halbleiterschicht (4) isoliert ist.

8. Supraleitungs-Bauelement nach einem der Ansprüche 1 bis 6, bei dem die Halbleiterschicht (100, 101) aus einem n-leitenden Halbleitermaterial besteht, wobei die Halbleiterschicht (100, 101) und die Steuerelektrode (104) einen pn-Übergang zwischen sich bilden.

9. Halbleiter-Bauelement nach einem der vorstehenden Ansprüche, bei dem die Halbleiterschicht (4) einen Bereich aufweist, der dem Abstand entspricht und der dünner als die anderen Bereiche derselben ist.

10. Supraleitungs-Bauelement nach Anspruch 9, bei dem der Supraleitungsstrom durch den dünneren Bereich fließt.

11. Supraleitungs-Bauelement nach Anspruch 9 oder Anspruch 10, bei dem der dünnere Bereich ein vertiefter, dünnerer Bereich eines Halbleitersubstrats ist.

12. Supraleitungs-Bauelement nach einem der vorstehenden Ansprüche, bei dem die Halbleiterschicht (4) eine auf einem Halbleitersubstrat liegende Halbleiterschicht ist.

13. Supraleitungs-Bauelement nach einem der Ansprüche 1 bis 11, bei dem die Halbleiterschicht (4) ein in einem Halbleitersubstrat (1) ausgebildeter Bereich ist.

14. Supraleitungs-Bauelement nach einem der vorstehenden Ansprüche, bei dem an die Steuerelektrode (2) eine Steuerspannung zum Einstellen des Supraleitungsstroms angelegt wird.

15. Supraleitungs-Bauelement nach einem der vorstehenden Ansprüche, bei dem die Halbleiterschicht (4, 101) ein Siliciumhalbleiter ist, der Abstand zwischen den zwei supraleitenden Elektroden (5, 6, 102, 103) nicht größer als 300 nm ist und die Steuerelektrode (2, 104) den normalen Tunnelwiderstand der supraleitenden, schwachen Verbindung zwischen den supraleitenden Elektroden (5, 6, 102, 103) einstellt.

**Revendications**

1. Dispositif supraconducteur comprenant :

   une couche semiconductrice (4, 100, 101) ayant un côté supérieur et un côté inférieur, une première et une seconde électrodes supraconductrices (5, 6, 102, 103, 202, 203) situées sur le côté supérieur de la couche semiconductrice (4, 100, 101) ayant un espace entre elles et une électrode de contrôle (2, 104) pour contrôler du courant supraconducteur circulant entre lesdites électrodes supraconductrices (5, 6, 102, 103, 202, 203) à travers la couche semiconductrice (4, 100, 101) ;

   caractérisé en ce que :

   l'électrode de contrôle (2, 104) est située sur le côté inférieur de la couche semiconductrice (4, 100, 101) et opposée à l'espace.

2. Dispositif supraconducteur selon la revendication 1, dans lequel la largeur de l'électrode de contrôle (2) est plus grande que l'espace entre les électrodes supraconductrices (5, 6).

3. Dispositif supraconducteur selon la revendication 1 ou la revendication 2, dans lequel les première et seconde électrodes supraconductrices (5, 6, 102, 103, 202, 203) sont couplées par une liaison faible supraconductrice par la couche semiconductrice (4, 100, 101).

4. Dispositif supraconducteur selon l'une quelconque des revendications précédentes, dans lequel la couche semiconductrice (4) est utilisée en une barrière de tunnel au courant supraconducteur.

5. Dispositif supraconducteur selon l'une quelconque des revendications 1 à 4, dans lequel l'électrode de contrôle (2) est située afin d'être enfouie dans un substrat semiconducteur (1).

6. Dispositif supraconducteur selon l'une quelconque des revendications précédentes, dans lequel la couche semiconductrice (4, 100, 101) est constituée d'un matériau semiconducteur ayant un premier type de conductivité et l'électrode de contrôle (2, 104) est constituée d'un matériau semiconducteur ayant un second type de conductivité.

7. Dispositif supraconducteur selon l'une quelconque des revendications précédentes, dans lequel l'électrode de contrôle (2) est isolée de la couche semiconductrice (4).

8. Dispositif supraconducteur selon l'une quelconque des revendications 1 à 6, dans lequel la couche semiconductrice (100, 101) est constituée d'un matériau semiconducteur du type n, de la sorte la couche semiconductrice (100, 101) et l'électrode de contrôle (104) forment entre elles une jonction p-n.

9. Dispositif supraconducteur selon l'une quelconque des revendications précédentes, dans lequel la couche semiconductrice (4) a une région qui correspond à l'espace et est plus mince que les autres régions de celle-ci.

10. Dispositif supraconducteur selon la revendication 9, dans lequel le courant supraconducteur circule à travers la région plus mince.

11. Dispositif supraconducteur selon la revendication 9 ou la revendication 10, dans lequel la région plus mince est une région plus mince évidée d'un substrat semiconducteur.

12. Dispositif supraconducteur selon l'une quelconque des revendications précédentes, dans lequel la couche semiconductrice (4) est une couche semiconductrice située sur un substrat semiconducteur.

13. Dispositif supraconducteur selon l'une quelconque des revendications 1 à 11, dans lequel la couche semiconductrice (4) est une région formée dans un substrat semiconducteur (1).

14. Dispositif supraconducteur selon l'une quelconque des revendications précédentes, dans lequel une tension de contrôle est appliquée à l'électrode de contrôle (2) afin de contrôler le courant supraconducteur.

15. Dispositif supraconducteur selon l'une quelconque des revendications précédentes, dans lequel la couche semiconductrice (4, 101) est un semiconducteur de silicium ; l'espace entre les deux électrodes supraconductrices (5, 6, 102, 103) n'est pas supérieur à 300nm et l'électrode de contrôle (2, 104) contrôle une résistance de tunnel normale de la liaison faible supraconductrice entre les électrodes supraconductrices précitées (5, 6, 102, 103).

FIG. 1

FIG. 2

FIG. 3

## FIG. 4

## FIG. 5

## FIG. 6

## FIG. 7

## FIG. 8

## FIG. 9

## FIG. 10

## FIG. 11

*FIG. 12*

*FIG. 15*

14

# *FIG. 13*

## FIG. 14